# EUROPEAN PATENT APPLICATION

(11) **EP 1 564 825 A2**
(43) Date of publication of application: **17.08.2005**
(21) Application number: 04257663.7
(22) Date of filing: 09.12.2004
(51) Int. Cl.: H01L 51/00

(54) **Composite articles having diffusion barriers and devices incorporating them**

(30) Priority: 17.02.2004 US 779373
(71) Applicant: GENERAL ELECTRIC COMPANY, Schenectady, NY 12345 (US)
(72) Inventor: Schaepkens, Marc, Ballston Lake, New York 12019 (US); Heller, Christian Maria Anton, Albany, New York 12203 (US); McConnelee, Paul Alan, Schenectady, New York 12306 (US); Wang, Hua, Clifton Park, New York 12065 (US); Flanagan, Kevin Warner, Albany, New York 12203 (US)
(74) Representative: Szary, Anne Catherine, Dr.

(57) **Abstract**

A composite article (10) comprises two polymeric substrate layers (20, 24), each of which has at least a diffusion-inhibiting barrier (30, 34) on one of the surfaces. The diffusion-inhibiting barriers (30, 34) are disposed such that they face each other within the composite article (10). Electronic devices (110) are disposed on such composite article (10) to reduce the rate of diffusion of chemical species in the environment into the devices (110).

## Description

The present invention relates generally to composite films having improved resistance to diffusion of chemical species and to devices incorporating such composite films. In particular, the present invention relates to electronic devices having at least a sensitive material, which devices incorporate such composite films and have improved stability in the environment.

Electroluminescent ("EL") devices, which may be classified as either organic or inorganic, are well known in graphic display and imaging art. EL devices have been produced in different shapes for many applications. Inorganic EL devices, however, typically suffer from a required high activation voltage and low brightness. On the other hand, organic EL devices ("OELDs"), which have been developed more recently, offer the benefits of lower activation voltage and higher brightness in addition to simple manufacture, and, thus, the promise of more widespread applications.

An OELD is typically a thin film structure formed on a substrate such as glass or transparent plastic. A light-emitting layer of an organic EL material and optional adjacent semiconductor layers are sandwiched between a cathode and an anode. The semiconductor layers may be either hole (positive charge)-injecting or electron (negative charge)-injecting layers and also comprise organic materials. The material for the light-emitting layer may be selected from many organic EL materials. The light emitting organic layer may itself consist of multiple sublayers, each comprising a different organic EL material. State-of-the-art organic EL materials can emit electromagnetic ("EM") radiation having narrow ranges of wavelengths in the visible spectrum. Unless specifically stated, the terms "EM radiation" and "light" are used interchangeably in this disclosure to mean generally radiation having wavelengths in the range from ultraviolet ("UV") to mid-infrared ("mid-IR") or, in other words, wavelengths in the range from about 300 nm to about 10 micrometer. To achieve white light, prior-art devices incorporate closely arranged OELDs emitting blue, green, and red light. These colors are mixed to produce white light.

Conventional OELDs are built on glass substrates because of a combination of transparency and low permeability of glass to oxygen and water vapor. Otherwise, a substrate allowing a high permeability of these and other reactive species can lead to corrosion or other degradation of the devices. However, glass substrates are not suitable for certain applications in which flexibility is desired. In addition, manufacturing processes involving large glass substrates are inherently slow and, therefore, result in high manufacturing cost. Flexible plastic substrates have been used to build OLEDs. However, these substrates are not impervious to oxygen and water vapor, and, thus, are not suitable per se for the manufacture of long-lasting OELDs. In order to improve the resistance of these substrates to oxygen and water vapor, it has been suggested that a plurality of alternating layers of organic and inorganic materials be applied to a surface of a substrate. It has been suggested that in such multilayer barriers, the organic materials act to mask any defects in adjacent inorganic materials to reduce the diffusion rates of oxygen and/or water vapor through the channels made possible by the defects in the inorganic materials. However, organic materials typically can tolerate higher strains than inorganic materials before breakage. Therefore, as a plastic substrate having a barrier that comprises inorganic materials is bent, the compression or tension, as the case may be, imposed on the inorganic materials tends to result in early cracks therein. Thus, a plastic substrate having such a barrier loses its flexibility advantage.

Therefore, there is a continued need to have robust films that have both flexibility and reduced diffusion rates of environmentally reactive materials. It is also very desirable to provide such films, the barrier property of which is not easily compromised under compression or tension. It is also very desirable to provide such films to produce flexible OELDs that are robust against degradation due to environmental elements.

### SUMMARY OF THE INVENTION

The present invention provides a composite article that comprises a first and a second polymeric substrate layer. Each of the polymeric substrate layers is coated with at least a diffusion-inhibiting barrier (or sometimes hereinafter interchangeably called "diffusion-inhibiting coating"). The polymeric substrate layers coated with such diffusion-inhibiting barriers are attached together to form the composite article such that the diffusion-inhibiting barriers face each other within the composite article.

According to one aspect of the present invention, the coated substrate layers are laminated together with an adhesive that separates the diffusion-inhibiting barriers.

According to another aspect of the present invention, the diffusion-inhibiting barrier comprises a material, the composition of which varies across a thickness thereof. Such a barrier will be termed interchangeably hereinafter a "diffusion barrier having graded composition," "graded-composition diffusion barrier," or "graded-composition barrier. "

According to still another aspect of the present invention, the diffusion-inhibiting barrier comprises a multilayer structure of alternating sublayers of an organic polymeric material and an inorganic material. Such a barrier will be termed hereinafter a "multilayer diffusion barrier," or "multilayer barrier."

According to still another aspect, the composite article of the present invention forms a foundation or a protective layer upon which an electronic device is disposed, which is sensitive to chemical species present in the environment. Thus, the composite article effectively prevents or inhibits the diffusion of such chemical species into the electronic device.

The present invention also provides a method for making a composite article. The method comprises: (a) providing a first and a second polymeric substrate layer; (b) forming at least a diffusion-inhibiting barrier on a surface of each of the polymeric substrate layers; and (c) attaching the polymeric substrate layers having the diffusion-inhibiting barriers thereon to form the composite article such that the diffusion-inhibiting barriers face each other within the composite article.

Other features and advantages of the present invention will be apparent from a perusal of the following detailed description of the invention and the accompanying drawings in which the same numerals refer to like elements.

### BRIEF DESCRIPTION OF THE DRAWINGS

Figure 1 is a schematic diagram of a first embodiment of the composite article of the present invention.
Figure 2 is a schematic diagram of a diffusion-inhibiting barrier that comprises a plurality of alternating sublayers of inorganic and organic materials.
Figure 3 is a schematic diagram of a second embodiment of the composite article of the present invention.
Figure 4 is a schematic diagram of a third embodiment of the composite article of the present invention.
Figure 5 is a schematic diagram of a fourth embodiment of the composite article of the present invention.
Figure 6 shows schematically an electronic device on a composite article of the present invention.
Figure 7 shows schematically an electronic device encapsulated between two composite articles of the present invention.

### DETAILED DESCRIPTION OF THE INVENTION

The present invention, in one aspect, provides a composite article that comprises two polymeric substrate layers (a first and a second polymeric substrate layer). Each of the polymeric substrate layers is coated with at least a diffusion-inhibiting barrier. The polymeric substrate layers coated with such diffusion-inhibiting barriers are attached together to form the composite article such that the diffusion-inhibiting barriers face each other within the composite article. The diffusion-inhibiting barriers reduce the diffusion rates of chemical species through the composite article. A composite article of the present invention can advantageously tolerate a large degree of compression or tension due to bending or flexing without seriously compromising its diffusion-inhibiting property, partially because the inorganic layers are near the symmetry center of the composite article. In addition, as a result of attaching of two diffusion-inhibiting barriers, the structure possesses an improved diffusion-inhibiting property relative to structures having single diffusion-inhibiting barriers. Another advantage is that the inorganic layers are protected on both sides from accidental damage by relatively thick polymer films.

Such a composite article finds at least one use in providing protection to many devices or components; e.g., electronic devices, that are susceptible to reactive chemical species normally encountered in the environment. In another example, such a composite article can advantageously be used in packaging of materials, such as foodstuffs, that are easily spoiled by chemical or biological agents normally existing in the environment.

Organic semiconducting materials, such as light-emitting material, and/or cathode materials in OELDs are susceptible to attack or degradation by reactive species existing in the environment, such as oxygen, water vapor, hydrogen sulfide, SOₓ, NOₓ, solvents, etc. Films or articles having a diffusion-inhibiting barrier are particularly useful as protective elements to extend the life of these devices and render them more commercially viable.

In one embodiment, a diffusion-inhibiting barrier of the present invention may be made by depositing reaction or recombination products of reacting species onto a substrate or film. In one embodiment, the substrate comprises a polymeric material, such as a substantially transparent polymeric material. The term "substantially transparent" means allowing at least 50 percent, preferably at least 80 percent, and more preferably at least 90 percent of visible light to pass through a thickness of about 0.5 micrometer at an incident angle of less than about 10 degrees.

Substrate materials that benefit from having a diffusion-inhibiting barrier or coating are organic polymeric materials; such as polyethyleneterephthalate ("PET"); polyacrylates; polycarbonate; silicone; epoxy resins; silicone-functionalized epoxy resins; polyester such as Mylar (made by E.I. du Pont de Nemours & Co.); polyimide such as Kapton H or Kapton E (made by du Pont), Apical AV (made by Kanegafugi Chemical Industry Company), Upilex (made by UBE Industries, Ltd.); polyethersulfones ("PES," made by Sumitomo); polyetherimide such as Ultem (made by General Electric Company); and polyethylenenaphthalene ("PEN").

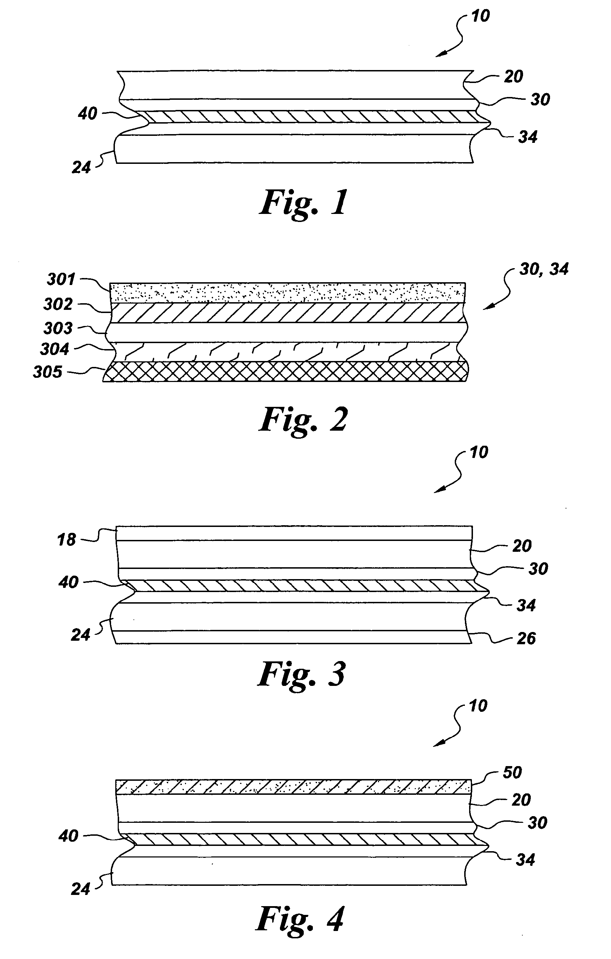

Figure 1 is a schematic diagram of the first embodiment of a composite article of the present invention. Composite article 10 comprises polymeric substrates 20 and 24, which may be made of the same or different materials selected from among those disclosed immediately above. Substrates 20 and 24 can have the same or different thicknesses. For example, the thickness of each of substrates 20 and 24 can be on the order of about 0.5 mm to 2 mm. In some applications, the desirable thickness may be less than 0.5 mm; for example, from about 50 µm to about 500 µm. At least one surface of each of substrates 20 and 24 is coated with at least a diffusion-inhibiting barrier (30, 34). Substrates 20 and 24 having diffusion-inhibiting barriers 30 and 34 coated thereon are attached together with an adhesive layer 40 to form composite article 10 such that diffusion-inhibiting barriers 30 and 34 face each other within composite article 10. In other words, after composite article 10 has been formed, diffusion-inhibiting barriers 30 and 34 occupy an internal space within composite article 10.

Substrates 20 and 24 having diffusion-inhibiting barriers 30 and 34 coated thereon are attached together by a lamination process using vacuum, heat (when the adhesive is thermally curable), pressure, or a combination thereof. The appropriate lamination temperature and pressure are chosen according to the characteristic of the adhesive. In another embodiment, the adhesive may be curable by ultraviolet ("UV") radiation or an electron beam. Such an adhesive may be used alone or in conjunction with vacuum, heat, or pressure in the lamination process. Temperature-sensitive adhesives ("TSAs") are typically water-based latexes. Preferably, the polymer or polymers contained in the latex have glass transition temperature (Tg) at least 10 °C higher than the highest temperature of the lamination process. Non-limiting examples of polymers used in the latex are polyurethane, polyethylene, poly(methyl acrylate), and poly(ethylene-vinyl acetate).

Typically, pressure-sensitive adhesives ("PSAs") and radiation-curable adhesives are thermally stable up to about 150 °C, or even 200 °C. Non-limiting examples of PSAs are tacky elastomers, such as block copolymers of styrene/isoprene, styrene/butadiene, butyl rubbers, polyisobutylene, silicones, and acrylate copolymers.

In one embodiment, the composition of diffusion-inhibiting barriers 30 and 34 varies across the thickness thereof. Such diffusion-inhibiting barriers are termed "graded-composition diffusion barriers" or simply "graded-composition barrier." Suitable compositions of regions across the thickness of graded-composition barrier are organic, inorganic, or ceramic materials. These materials are typically reaction or recombination products of reacting plasma species and are deposited onto the substrate surface. Organic coating materials typically comprise carbon, hydrogen, oxygen, and optionally other minor elements, such as sulfur, nitrogen, silicon, etc., depending on the types of reactants. Suitable reactants that result in organic compositions in the coating are straight or branched alkanes, alkenes, alkynes, alcohols, aldehydes, ethers, alkylene oxides, aromatics, etc., having up to 15 carbon atoms. Inorganic and ceramic coating materials typically comprise oxide; nitride; carbide; boride; or combinations thereof of elements of Groups IIA, IIIA, IVA, VA, VIA, VIIA, IB, and IIB; metals of Groups IIIB, IVB, and VB; and rare-earth metals. (It should be noted that the instant disclosure uses the names of the Groups of the Periodic Table of the Elements designated by the International Union of Pure and Applied Chemistry. See; e.g., R.J. Lewis, "Hawley's Condensed Chemical Dictionary," 13^{th} ed., John Wiley & Sons, Inc., New York (1997).) For example, silicon carbide can be deposited onto a substrate by recombination of plasmas generated from silane (SiH₄) and an organic material, such as methane or xylene. Silicon oxycarbide can be deposited from plasmas generated from silane, methane, and oxygen or silane and propylene oxide. Silicon oxycarbide also can be deposited from plasmas generated from organosilicone precursors, such as tetraethoxysilane (TEOS), hexamethyldisiloxane (HMDSO), hexamethyldisilazane (HMDSN), or octamethylcyclotetrasiloxane (D4). Silicon nitride can be deposited from plasmas generated from silane and ammonia. Aluminum oxycarbonitride can be deposited from a plasma generated from a mixture of aluminum tartrate and ammonia. Other combinations of reactants may be chosen to obtain a desired coating composition. The choice of the particular reactants is within the skills of the artisans. In one embodiment, a graded composition of the coating is obtained by changing the compositions of the reactants fed into the reactor chamber during the deposition of reaction products to form the coating. Varying the relative supply rates or changing the identities of the reacting species results in a diffusion-inhibiting barrier or coating that has a graded composition across its thickness. In another embodiment, a graded composition results from implantation or penetration of a material being deposited into an existing material. Graded compositions can offer a benefit of improved adhesion of the coating to the underlying layer.

Coating thickness is typically in the range from about 10 nm to about 10000 nm, preferably from about 10 nm to about 1000 nm, and more preferably from about 10 nm to about 200 nm. It may be desired to choose a coating thickness that does not impede the transmission of light through the substrate, such as a reduction in light transmission being less than about 20 percent, preferably less than about 10 percent, and more preferably less than about 5 percent. The coating may be formed by one of many deposition techniques, such as plasma-enhanced chemical-vapor deposition ("PECVD"), radio-frequency plasma-enhanced chemical-vapor deposition ("RFPECVD"), expanding thermal-plasma chemical-vapor deposition ("ETPCVD"), sputtering including reactive sputtering, electron-cyclotron-resonance plasma-enhanced chemical-vapor deposition (ECRPECVD"), inductively coupled plasma-enhanced chemical-vapor deposition ("ICPECVD"), or combinations thereof. Reactors and techniques suitable for carrying out a deposition of a material of the coating are disclosed in U.S. Patent Application 10/065,018 (US-2004-0046497); which is incorporated herein by reference.

In another embodiment, the diffusion-inhibiting barrier or coating comprises a plurality of alternating sublayers of inorganic and organic material. For example, Figure 2 schematically shows diffusion-inhibiting coating 30 or 34 that comprises alternating sublayers 301, 302, 303, 304, and 305 of inorganic and organic materials. Although Figure 2 shows 5 sublayers, any number of sublayers greater than 2 would be suitable if the diffusion-inhibiting property of the entire coating is achieved. For example, sublayers 301, 303, and 305 may comprise inorganic materials, and sublayers 302 and 304 may comprise organic materials, or vice versa. Suitable inorganic materials include, but are not limited to, metals, metal oxides, metal nitrides, metal carbides, metal oxynitrides, metal oxyborides, and combinations thereof. Metals include, but are not limited to, aluminum, titanium, indium, tin, tantalum, zirconium, niobium, hafnium, yttrium, nickel, tungsten, chromium, zinc, alloys thereof, and combinations thereof. Metal oxides include, but are not limited to, silicon oxide, aluminum oxide, titanium oxide, indium oxide, tin oxide, indium tin oxide, tantalum oxide, zirconium oxide, niobium oxide, hafnium oxide, yttrium oxide, nickel oxide, tungsten oxide, chromium oxide, zinc oxide, and combinations thereof. Metal nitrides include, but are not limited to, aluminum nitride, silicon nitride, boron nitride, germanium nitride, chromium nitride, nickel nitride, and combinations thereof. Metal carbides include, but are not limited to, boron carbide, tungsten carbide, silicon carbide, and combinations thereof. Metal oxynitrides include, but are not limited to, aluminum oxynitride, silicon oxynitride, boron oxynitride, and combinations thereof. Metal oxyborides include, but are not limited to, zirconium oxyboride, titanium oxyboride, and combinations thereof. The barrier layers may be deposited by any suitable process including, but not limited to, conventional vacuum processes such as sputtering, evaporation, sublimation, chemical vapor deposition (CVD), plasma enhanced chemical vapor deposition (PECVD), electron cyclotron resonance-plasma enhanced vapor deposition (ECR-PECVD), and combinations thereof. The thickness of an inorganic layer is in the range from about 5 nm to about 100 nm; preferably, from about 5 nm to about 50 nm. The different inorganic sublayers of a diffusion-inhibiting coating can comprise the same or different materials, and can have the same or different thicknesses.

Suitable materials for an organic sublayer are organic polymers that include, but are not limited to, polyacrylates, polyurethanes, polyamides, polyimides, polybutylenes, isobutylene isoprene, polyolefins, epoxies, parylene, benzocyclobutadiene, polynorbomenes, polyarylethers, polycarbonate, alkyds, polyaniline, ethylene vinyl acetate, ethylene acrylic acid, derivatives thereof, and combinations thereof. Modified versions of the various polymer types are included within the meaning of the polymer, for example, olefins include modified olefins, such as ethylene vinyl acetate. Also, as used herein, polyacrylates include acrylate containing polymers and methacrylate containing polymers. The thickness of an organic sublayer is in the range from about 50 nm to about 10,000 nm. The different organic sublayers of a diffusion-inhibiting coating can comprise the same or different materials, and can have the same or different thicknesses. An organic sublayer can be deposited onto an underlying sublayer by a vacuum or an atmospheric deposition process. The organic sublayer may be formed by depositing a layer of liquid and subsequently processing the layer of liquid into a solid film. Vacuum deposition of the organic sublayers includes, but is not limited to, flash evaporation of polymer precursors with in situ polymerization under vacuum, and plasma deposition and polymerization of polymer precursors. Atmospheric processes for depositing the organic sublayers include, but are not limited to, spin coating, dip coating, screen printing, ink-jet printing, and spraying.

In another embodiment, as shown schematically in Figure 3, a composite article 10 further comprises a chemically resistant hardcoat 18 or 26 on a surface of each of polymeric substrate layers 20 and 24 opposite to diffusion-inhibiting barriers 30 and 34. Chemically resistant hardcoats 18 and 26 comprises a UV-radiation curable or thermally curable coating composition, which is substantially free of non-reactive volatile components, such as solvents. The UV-radiation curable coating compositions generally comprise monomers or oligomers containing acrylic, methacrylic, and vinylic moieties. Thermally curable coating compositions generally comprise monomers or oligomers containing epoxy moieties. Various compositions and methods for manufacture of the chemically resistant hardcoats are disclosed in U.S. Patent number 5,455, 105; which is incorporated herein by reference.

In another embodiment, as shown schematically in Figure 4, composite article 10 further comprises an electrically conducting layer 50 on a surface of one of polymeric substrates 20 and 24 opposite a corresponding diffusion-inhibiting barrier 30 or 34. For example, in one embodiment, electrically conducting layer 50 comprises a substantially transparent conducting oxide, such as tin oxide, indium oxide, zinc oxide, indium tin oxide ("ITO"), indium zinc oxide, cadmium tin oxide, or mixtures thereof. Such an electrically conducting layer can serve as an electrode for an electronic device that is built on composite article 10, which serves as a support thereof. Layer 50 can be deposited on the underlying layer by a method selected from the group consisting of physical vapor deposition, chemical vapor deposition, ion beam-assisted deposition, or sputtering. The thickness of layer 50 is in the range from about 10 nm to about 500 nm, preferably from about 10 nm to about 200 nm, and more preferably from about 50 nm to about 200 nm.

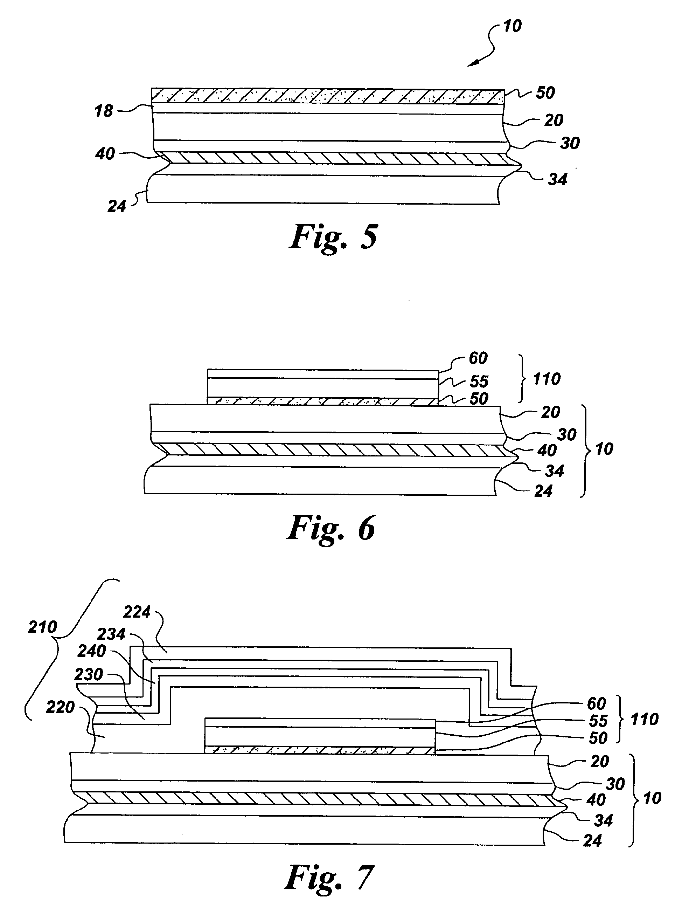

In another embodiment, as shown schematically in Figure 5, electrically conducting layer 50 is disposed on one of chemically resistant hardcoat 18 or 26.

### EXAMPLE: Manufacture of a composite article of the present invention

Two 75-micrometer thick polycarbonate films were coated on one surface with a graded (inorganic/organic) barrier coating with a composition that was initially inorganic in nature, then continuously changed into a dominantly organic nature, and finally changed back to an inorganic nature. The graded barrier coatings were deposited using a parallel plate plasma enhanced chemical vapor deposition process (PECVD) at 0.2 mm Hg operating pressure. In the initial and final stage of the process, a mixture of silane, ammonia, and helium were fed to the PECVD reactor, resulting in the deposition of an amorphous silicon nitride material. In the middle stage of the process, a mixture of vinyltrimethylsilane and argon were fed to the PECVD reactor, resulting in the deposition of a silicon containing polymeric material.

The two polycarbonate films coated with such graded barrier coatings were subsequently laminated together using a pressure sensitive adhesive, such as 3M™ Optically Clear Adhesive 8141, with the barrier coatings facing each other. The lamination was performed using a vacuum laminator. The adhesive was supplied with 2 liners. The liner was first removed on one side of the adhesive film and the adhesive film was laminated to the barrier coated surface of the first barrier-coated polycarbonate film. Then the second liner was removed from the adhesive film and the second barrier-coated polycarbonate film was laminated to the adhesive with the barrier coated side facing the adhesive.

The moisture permeation rate of the laminated structure was subsequently measured using a calcium corrosion test somewhat similar to the one described by G. Nisato et al. (Asia Display/IDW '01, pp. 1435-38) and compared to the moisture permeation rate of a single 75-micrometer thick graded (inorganic/organic) barrier coated polycarbonate. It was found that the laminated structure had a permeation rate on the order of 5 x 10⁻⁴ g/m²/day at 22°C and 50% relative humidity, while the single barrier coated polycarbonate film has a permeation rate on the order of 3 x 10⁻³ g/m²/day at 22°C and 50% relative humidity. The laminated structure thus had a barrier performance that was better than a factor of 2 relative to a single barrier coating, which is the expected improvement based on the theory of lamination of two coated substrates.

A composite article 10 of the present invention having electrically conducting layer 50 that comprises, for example, ITO can be used as a support for an electronic device, which uses electrically conducting layer 50 as one of the electrodes, and includes an electronically active material disposed between layer 50 and another electrode. One example of such an electronic device is an organic EL device (OELD), the electronically active material of which converts electrical energy to light. For example, Figure 6 shows schematically an apparatus 100 that comprises an OELD 110 built on a composite article 10 of the present invention. OELD 110 comprises: (a) anode 50 that comprises a transparent conducting oxide material such as ITO; (b) cathode 60; and (c) organic EL material 55 disposed between anode 50 and cathode 60. OELD 110 can further comprise additional layers that serve to enhance the charge injection or transport, or to convert light emitted by organic EL material 55 to light having other wavelengths. Suitable materials for such additional layers are disclosed in U.S. Patent 6,515,314; which is incorporated herein by reference.

In one embodiment, composite article 10 and electronic device 110 can be formed separately and then attached together with a lamination process, using vacuum, heat, pressure, or a combination thereof.

Furthermore, an electronic device may be encapsulated between two composite articles of the present invention; for example, as shown in Figure 7. Electronic device 110 that comprises electronically active material 55 disposed between two electrodes 50 and 60 is disposed between two composite articles 10 and 210. Each of the two composite articles 10 and 210 comprises two polymeric substrate layers (20, 24, 220, 224). A surface of each of polymeric substrate layers 20, 24, 220, and 224 is coated with a diffusion-inhibiting barrier (30, 34, 230, 234). Two of such coated polymeric substrate layers are attached together such that the diffusion-inhibiting barriers face each other to form composite articles 10 and 210. In one embodiment, the assembly of composite articles 10 and 210 and electronic device 110 can be laminated together using vacuum, heat, pressure, or a combination thereof.

Another example of such electronic devices is an organic photovoltaic ("PV") device that comprises organic PV materials disposed between a pair of electrodes. The organic PV materials, which are typically a semiconducting materials and comprise an electron donor and an electron acceptor disposed adjacent to each other.

According to another aspect, the present invention provides a method for making a composite article. The method comprises: (a) providing a first polymeric substrate layer and a second polymeric substrate layer; (b) forming at least a diffusion-inhibiting barrier on a surface of each of said polymeric substrate layers to produce coated polymeric substrate layers; and (c) attaching said coated polymeric substrate layers together to produce said composite article such that diffusion-inhibiting barriers on said coated polymeric substrate layers face each other within said composite article.

According to another aspect, the present invention provides a method for making a device or apparatus. The method comprises: (a) forming a composite support article; and (b) disposing an electronic device on the composite support article. The step of forming comprises: (1) providing a first polymeric substrate layer and a second polymeric substrate layer; (2) forming at least a diffusion-inhibiting barrier on a surface of each of said polymeric substrate layers to produce a coated polymeric substrate layers; and (3) attaching said coated polymeric substrate layers together to produce said composite article such that diffusion-inhibiting barriers on said coated polymeric substrate layers face each other within said composite article.

The method can further comprises disposing a second composite support article of the present invention on the electronic device. The electronic device and the composite support articles can be formed separately and then laminated together using vacuum, heat, pressure, or a combination thereof.

While various embodiments are described herein, it will be appreciated from the specification that various combinations of elements, variations, equivalents, or improvements therein may be made by those skilled in the art, and are still within the scope of the invention as defined in the appended claims.

## Claims

1. A composite article (10) comprising a first polymeric substrate layer (20) and a second polymeric substrate layer (24), each of said polymeric substrate layers (20, 24) having at least a diffusion-inhibiting barrier (30, 34) disposed on a surface thereof, wherein diffusion-inhibiting barriers (30, 34) on said substrate layers (20, 24) face each other within said composite article (10).

2. The composite article (10) according to claim 1, wherein compositions of regions across a thickness of said at least one diffusion-inhibiting barrier (30, 34) are selected from the group consisting of organic materials and inorganic materials.

3. The composite article according to claim 1, wherein at least one diffusion-inhibiting barrier (30, 34) comprises a plurality of alternating sublayers (301, 302, 303, 304, 305) of at least an organic polymeric material and at least an inorganic material.

4. An apparatus (100) comprising:
a composite article (10) that comprises a first polymeric substrate layer (20) and a second polymeric substrate layer (24), each of said polymeric substrate layers (20, 24) having at least a diffusion-inhibiting barrier (30, 34) disposed on a surface thereof, wherein diffusion-inhibiting barriers (30, 34) on said substrate layers (20, 24) face each other within said composite article (10); and
an electronic device (110) disposed on said composite article (10).

5. The apparatus according to claim 4, wherein at least one diffusion-inhibiting barrier (30, 34) comprises a material, the composition of which varies across a thickness thereof.

6. The apparatus (100) according to claim 4 or claim 5, wherein said electronic device (110) is an organic electroluminescent device.

7. The apparatus (100) according to any one of claims 4, 5 or 6 wherein said electronic device (110) is an organic photovoltaic device.

8. A method for making a composite article (10), said method comprising:
providing a first polymeric substrate layer (20) and a second polymeric substrate layer (24);
forming at least a diffusion-inhibiting barrier (30, 34) on a surface of each of said polymeric substrate layers (20, 24) to produce coated polymeric substrate layers; and
attaching said coated polymeric substrate layers together to produce said composite article (10) such that diffusion-inhibiting barriers (30, 34) on said coated polymeric substrate layers face each other within said composite article (10).

9. A method for making an apparatus (100), said method comprising:
forming a composite support article (10), wherein said forming comprises: (1) providing a first polymeric substrate layer (20) and a second polymeric substrate layer (24); (2) forming at least a diffusion-inhibiting barrier (30, 34) on a surface of each of said polymeric substrate layers (20, 24) to produce a coated polymeric substrate layers; and (3) attaching said coated polymeric substrate layers together to produce said composite support article such that diffusion-inhibiting barriers (30, 34) on said coated polymeric substrate layers face each other within said composite support article (10); and
disposing an electronic device (101) on said composite support article (10).

10. The method according to claim 9, further disposing a second composite support article (210) on said electronic device (110).
